(19) **Europäisches Patentamt / European Patent Office / Office européen des brevets**

(11) **EP 1 503 218 B1**

(12) **EUROPEAN PATENT SPECIFICATION**

(45) Date of publication and mention of the grant of the patent:
**17.01.2007 Bulletin 2007/03**

(21) Application number: **03705237.0**

(22) Date of filing: **17.02.2003**

(51) Int Cl.:
*G01R 31/34* (2006.01)    *G01R 31/06* (2006.01)
*G01R 31/12* (2006.01)

(86) International application number:
**PCT/JP2003/001649**

(87) International publication number:
**WO 2003/091743 (06.11.2003 Gazette 2003/45)**

(54) **METHOD FOR DIAGNOSING DETERIORATION OF COIL AND SYSTEM FOR DIAGNOSING DETERIORATION OF COIL**

VERFAHREN ZUR DIAGNOSE DER VERSCHLECHTERUNG EINER SPULE UND SYSTEM ZUR DIAGNOSE DER VERSCHLECHTERUNG EINER SPULE

PROCEDE ET SYSTEME DE DIAGNOSTIC DE DETERIORATION DE BOBINE

(84) Designated Contracting States:
**FR**

(30) Priority: **26.04.2002 JP 2002126293**

(43) Date of publication of application:
**02.02.2005 Bulletin 2005/05**

(60) Divisional application:
**06126047.7**

(73) Proprietors:
- **KABUSHIKI KAISHA TOSHIBA**
  **Tokyo 105-8001 (JP)**
- **Toshiba Plant Systems & Services Corporation**
  **Tokyo 144-8721 (JP)**

(72) Inventors:
- **INOUE, Yoshiyuki**
  **Yokohama-Shi, Kanagawa 221-0801 (JP)**
- **HASEGAWA, Hiroshi**
  **Yokohama-Shi, Kanagawa 244-0812 (JP)**
- **TAKAHASHI, Shinji**
  **Kamakura-Shi, Kanagawa 247-0061 (JP)**
- **OGAWA, Hiroaki**
  **Sagamihara-Shi, Kanagawa 229-0004 (JP)**
- **SEKITO, Shinobu**
  **Yokohama-Shi, Kanagawa 236-0032 (JP)**

(74) Representative: **Joly, Jean-Jacques**
**Cabinet Beau de Loménie**
**158, rue de l'Université**
**75340 Paris Cédex 07 (FR)**

(56) References cited:
JP-A- 1 126 570      JP-A- 5 133 996
JP-A- 5 264 642      JP-A- 6 230 072
JP-A- 6 292 325      JP-A- 9 051 658
JP-A- 9 211 060      JP-A- 10 019 969
JP-A- 10 177 053     JP-A- 55 101 063
JP-U- 61 101 766     JP-U- 61 104 765
SU-A1- 1 728 809     US-A- 4 737 775
US-A- 5 682 102      US-B1- 6 225 813

- **PATENT ABSTRACTS OF JAPAN vol. 018, no. 031 (P-1677), 18 January 1994 (1994-01-18) & JP 05 264642 A (SHOWA ELECTRIC WIRE & CABLE CO LTD), 12 October 1993 (1993-10-12)**
- **INOUE Y ET AL: "Technology for detecting wet bars in water-cooled stator windings of turbine generators" ELECTRIC MACHINES AND DRIVES CONFERENCE, 2003. IEMDC'03. IEEE INTERNATIONAL JUNE 1-4, 2003, PISCATAWAY, NJ, USA,IEEE, vol. 2, 1 June 2003 (2003-06-01), pages 1337-1343, XP010643523 ISBN: 0-7803-7817-2**

**Description**

TECHNICAL FIELD

The present invention relates to a coil deterioration diagnostic method of detecting leakage of water from a conductor to an insulation layer at a time of an operation while directly cooling the conductor with water and diagnosing the insulation deterioration caused to a coil due to such leakage of water and also relates to a coil deterioration diagnosis apparatus to be applied to the diagnosis method mentioned above.

BACKGROUND ART

In a rotating electric machine, if its capacity increases, current flowing through a stator coil (stator windings) increases, so that temperature rises excessively due to Joule loss generated in the stator coil correspondingly, thereby making it difficult to design a rotating electric machine having a large capacity.

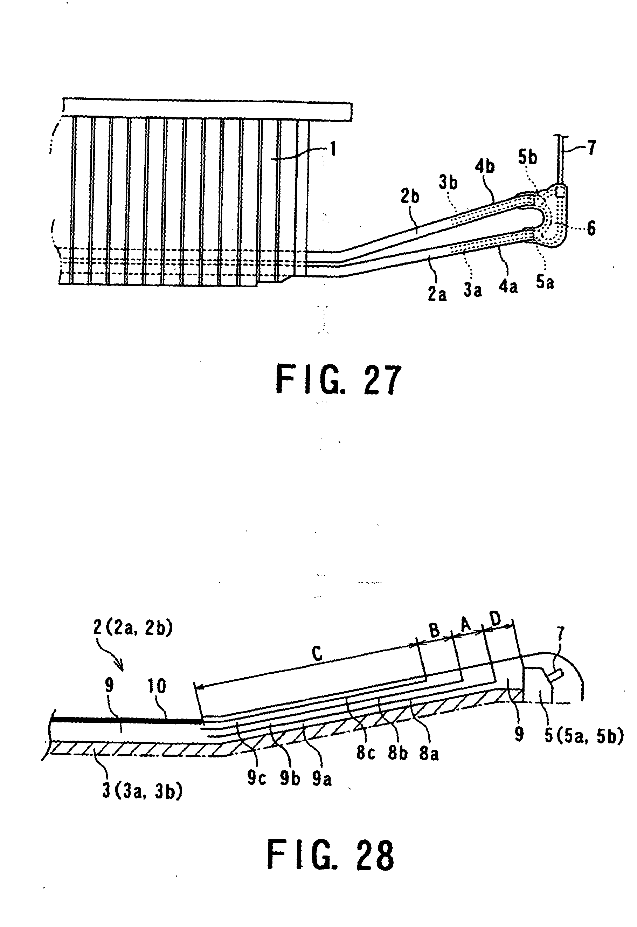

Thus, recently, there have been provided many types of large-capacity rotating electric machines in which the stator coil is cooled directly with water, and Fig. 27 shows one example of such structure.

Generally, a large-capacity rotating electric machine has a cylindrically formed stator core 1 formed with a plurality of slots inside the stator core 1, and a bottom coil 2b and an top coil 2a are placed in each slot as a pair.

The top coil 2a and the bottom coil 2b employ a wire comprised of conductors 3a, 3b made of hallow rectangular copper wire alone or a mixture of solid rectangular copper wire with hallow rectangular wire, these conductors 3a, 3b being formed rectangular in their sectional shape. Insulation layers 4a, 4b are disposed so as to cover them at their outer sides.

Moreover, in the upper and bottom coils 2a, 2b, clips 5a, 5b are brazed to end portions of the conductors 3a, 3b and the respective clips 5a, 5b are connected through a first conductor 6, so that the conductors 3a, 3b are cooled directly with deionized water or the like supplied from an insulating tube 7.

As a result of a long-term operation, the brazed portion between the conductors 3a, 3b and the clips 5a, 5b is deteriorated due to galvanic corrosion and a leak pass may be formed, through which water leaks into the insulation layers 4a, 4b, thereby likely causing an insulation breakdown.

Since the brazed portions between the conductors 3a, 3b and the clips 5a, 5b are covered with an insulation layer, this leak pass on the coil may not be visually recognized, a method of detecting leakage of water to the insulation layer has been already proposed in as disclosed, for example, in Japanese Patent Laid-Open Publication No. HEI 9-331656, Japanese Patent Laid-Open Publication No. HEI 9-51658 and Japanese Patent Laid-Open Publication No. HEI 10-177053.

These inventions utilize a phenomenon that capacitance of an insulation layer increases due to the leakage of water. With an electrode kept in contact with a coil outside the iron core, capacitance between a conductor and an electrode are measured, and if the measured capacitance is remarkably high, it is determined that water leaks out to the insulation layer.

Since these inventions only measure the capacitance of the insulation layer, the operation is simple and such methods are evaluated as a simple measuring method for discriminating the leakage of water to the insulation layer.

In some large capacity rotating electric machines, there are provided, as shown in Fig. 28 as a coil insulating structure, internal electrodes 8a, 8b, 8c disposed in insulation layers 9, 9a, 9b, 9c to reduce an electric field on the surface of the coil.

Although the internal electrodes 8a, 8b, 8c may be formed in two to four layers depending on insulation design, an example of three layers will be described herein.

In this coil insulating structure, the outside of a conductor 3 of a coil 2 (2a, 2b), which is composed of a pair of top coil 2a and bottom coil 2b, is covered with insulation layers 9, 9a to 9c and three internal electrodes 8a to 8c are mounted on the insulation layers 9, 9a to 9c. The internal electrode 8c on the outmost layer is connected to a low resistance layer 10 on the outmost layer of a straight portion of the coil 2 (2a, 2b), so that capacitance of the insulation layers 9a to 9c is divided by the intermediate internal electrodes 8a, 8b, thereby suppressing the electric field, to be small, on the outer surface of the insulation layer of a coil end portion. Further, a clip 5 (5a, 5b) is provided to an end of the coil end portion, the clip 5 having am insulating tube 7 for directly cooling the conductor 3 (3a, 3b) with water.

When the detection technique for detecting water leakage to the insulation layers 9, 9a to 9c in the coil 2 (2a, 2b), disclosed in the above-described Japanese Patent Laid-Open Publication, is applied to the rotating electric machine having such a coil insulation structure mentioned above, some problems will occur.

Now among the insulation layers 9, 9a to 9c in the coil 2 (2a, 2b), if, for the sake of convenience of explanation, a region A is called a first internal electrode space region, a region B is called a second internal electrode space region, a region C is called a third internal electrode space region, and a region D is called an internal electrode non-existing region, the above-described leaking water detection technique will be applied only to the region D.

However, in this region D, a thick ring is installed to suppress electromagnetic vibration of the coil 2 (2a, 2b) and this ring is tied up with a glass string. Therefore, there is no surplus room for mounting a measuring electrode.

Further, this region D is a region in which an armor of the clip 5 to be wounded with a mica insulation tape is overlapped with the insulation layer of the coil end portion, and its insulation thickness is not constant. Thus, since the capacitance is inversely proportional to the insulation thickness, it is impossible to correctly measure the leakage if the insulation thickness is not constant.

Therefore, it is impossible for the above-mentioned water leakage detection technique to substantially measure the capacitance.

Next, installing an electrode on the surface of the region A and measuring the capacitance between the installed electrode and the conductor 3 (3a, 3b) will be considered.

Generally, leaking water permeates in an insulation layer between the conductor 3 and the internal electrode 8a, which is the innermost layer, and unlikely permeates into a top portion of the internal electrode 8a. Thus, even if an electrode is mounted on the surface of the region A and the capacitance is measured by applying an AC voltage on the conductor 3 (3a, 3b), a measured electrostatic capacity value is mostly determined by the capacitance between the internal electrode 8a and the electrode on the surface of the coil. Accordingly, there is little difference between a sound coil and a wet coil. Thus, diagnosis of insulation deterioration based on the above-mentioned method will become meaningless.

As mentioned above, the technique already proposed cannot be applied to a rotating electric machine having such structure that the internal electrodes 8a to 8b are inserted into the insulation layers 9, 9a to 9c as it is, and a further improvement has been hence required.

Also known in the state of the art is US 5 682 102, which discloses an instrument for measuring the electrostatic capacity of a stator winding between a conductor and an electrode contacting a surface of the stator windings. Also, JP 05 264642 discloses a method of diagnosing deterioration of a high voltage electrical cable on the basis of a third harmonic component of a current flowing therethrough. US 4 737 775 relates to an apparatus for monitoring electrical insulation deterioration on the basis of a detected electrical field. US 6 225 813 relates to a tool for mapping the capacitance of insulation on a stator bar, without disassembling a corresponding rotor structure.

The present invention was achieved to meet such a requirement and an object of the present invention is to provide a coil deterioration diagnostic method and a coil deterioration diagnostic apparatus capable of detecting insulation deterioration of a coil generated by leakage of water from a conductor to an insulation layer upon operation with the conductor cooled directly with water, early, accurately and securely while operating easily.

DISCLOSURE OF THE INVENTION

To achieve the above object, a coil deterioration diagnostic method of the present invention is characterized in that a conductor to be cooled directly by a medium is covered with an insulation layer, a coil is constituted of the conductor and internal electrodes to be wrapped in the insulation layer, an AC voltage is applied to the conductor of the coil, a potential of the internal electrode or potentials of the internal electrodes are measured by a potential measuring probe facing the coil, and if a measured potential is higher than the potential of a sound coil, it is discriminated that the medium leaks out from the conductor to the insulation layer and an insulation thereof is deteriorated.

Further, to achieve the above object, the coil deterioration diagnostic method of the present invention is characterized in that a conductor to be cooled directly by a medium is covered with an insulation layer, a coil is constituted of the conductor and internal electrodes to be wrapped in the insulation layer, an AC voltage is applied to the conductor of the coil, a potential of the surface electrode mounted on the coil is measured by a potential measuring probe facing the surface electrode, and if a measured potential is higher than the potential of a sound coil, it is discriminated that the medium leaks out from the conductor to the insulation layer and an insulation thereof is deteriorated.

Further, to achieve the above object, the coil deterioration diagnostic method of the present invention is characterized in that a conductor to be cooled directly by a medium is covered with an insulation layer, a coil is constituted of the conductor and internal electrodes to be wrapped in the insulation layer, an AC voltage is applied to the conductor of the coil, a potential of the surface electrode mounted on the coil is measured by a high input impedance potentiometer and if the measured potential is higher than the potential of a sound coil, it is discriminated that the medium leaks out from the conductor to the insulation layer and an insulation thereof is deteriorated.

Further, to achieve the above object, the coil deterioration diagnostic method of the present invention is characterized in that a conductor to be cooled directly by a medium is covered with an insulation layer, a coil is constituted of the conductor and internal electrodes to be wrapped in the insulation layer, an AC voltage is applied to the conductor of the coil, the position of the internal electrode is confirmed by advancing or retracting a potential measuring probe along an axial direction of the coil, after the position of the internal electrode is confirmed, a potential of the internal electrode mounted in the insulation layer is measured and if a measured potential is higher than the potential of a sound coil, it is discriminated that the medium leaks out from the conductor to the insulation layer and an insulation thereof is deteriorated.

Further, to achieve the above object, the coil deterioration diagnostic method of the present invention is characterized in that a conductor to be cooled directly by a medium is covered with an insulation layer, a coil is constituted of the conductor and internal electrodes to be wrapped in the insulation layer, a DC voltage is applied to the conductor of the coil, the position of the internal electrode is confirmed by advancing or retracting a potential measuring probe along an axial direction of the coil, after the position of the internal electrode is confirmed, a potential of the surface electrode mounted on the coil is measured, and if a measured potential is higher than the potential of a sound coil, it is discriminated that the medium leaks out from the conductor to the insulation layer and an insulation thereof is deteriorated.

According to a preferred embodiment of the above-described coil deterioration diagnostic method, if a potential measured by either one of the internal electrode and the surface electrode has a difference in magnitude and phase with to a voltage applied to the conductor as compared with the phase of a sound coil, it is discriminated that the medium leaks out from the conductor to the insulation layer and an insulation thereof is deteriorated.

Further, to achieve the above-described object, the coil deterioration diagnostic method of the present invention is characterized in that a conductor to be cooled directly by a medium is covered with an insulation layer, a coil is constituted of the conductor and internal electrodes to be wrapped in the insulation layer, a DC voltage or a square wave voltage is applied to the conductor of the coil, and if the potential of a measured internal electrode or surface electrode is higher than the potential of a sound coil, it is discriminated that the medium leaks out from the conductor to the insulation layer and an insulation thereof is deteriorated.

Further, to achieve the above-described object, the coil deterioration diagnostic method of the present invention is characterized in that a conductor to be cooled directly by a medium is covered with an insulation layer, a coil is constituted of the conductor and internal electrodes to be wrapped in the insulation layer, the surface electrode mounted on the coil is grounded temporarily, and after the grounding is released, a step function-shaped DC voltage or a square wave voltage is applied to the conductor so as to measure the potential of the surface electrode.

Further, to achieve the above-described object, the coil deterioration diagnostic method of the present invention is characterized in that a conductor to be cooled directly by a medium is covered with an insulation layer, a coil is constituted of the conductor and internal electrodes to be wrapped in the insulation layer, any one of an AC voltage, a step function-shaped DC voltage and a square wave voltage is applied to the conductor of the coil, the potential of an external electrode connected to the surface electrode mounted on the coil and maintained at the same potential is measured, and if a measured potential is higher than the potential of a sound coil, it is discriminated that the medium leaks out from the conductor to the insulation layer and an insulation thereof is deteriorated.

According to a preferred embodiment of the coil deterioration diagnostic method, when the measured potential exceeds a limit value obtained by statistical processing, it is discriminated that the medium leaks out from the conductor to the insulation layer and an insulation is deteriorated. When the measured potentials differs depending on the positions of the internal electrode, a standard value for a ratio of the potential of the internal electrode having a different potential is preliminarily obtained and then converted to a potential of the internal electrode at the same position.

On the other hand, by adopting the above-described diagnostic method, the coil deterioration diagnostic apparatus of the present invention is characterized by comprising: a coil constituted of a conductor to be cooled directly by a medium and an internal electrode mounted in an insulation layer for covering the conductor; a power supply for applying a voltage to the conductor of the coil; a non-contact type surface potentiometer for measuring the potential of the internal electrode through a potential measuring probe; and a voltage reading device for measuring a voltage to be applied from the power supply to the conductor.

Further, by adopting the above-described diagnostic method, the coil deterioration diagnostic apparatus of the present invention is characterized by comprising: a coil constituted of a conductor to be cooled directly by a medium and an internal electrode mounted in an insulation layer for covering the conductor; a power supply for applying a voltage to the conductor of the coil; a surface electrode device mounted on the coil; a non-contact type surface potentiometer for measuring the potential of the surface electrode device through a potential measuring probe; and a voltage reading device for measuring a voltage applied from the power supply to the conductor.

In the diagnostic apparatus, the surface electrode device may be formed by bonding an insulation plate to the surface electrode. The surface electrode device may be formed by bonding the insulation plate to the surface electrode and the insulation plate is provided with protrusions. The surface electrode device may be formed by bonding the insulation plate to the surface electrode and the insulation plate is provided with a handle.

Further, the surface electrode device may be formed by bonding a pressing plate to the surface electrode through an elastic member. The surface electrode device may be formed by bonding a pressing plate to the surface electrode through an elastic member and the pressing plate is provided with a handle. The surface electrode device may be formed by providing the surface electrode with a handle.

The potential measuring probe may include a probe support member for maintaining a gap between a potential measuring window thereof and the surface electrode at a predetermined distance. Further, the potential measuring probe may be supported by a probe supporting device extending from the pressing plate for supporting the surface electrode and further comprises an external electrode connected to the surface electrode and provided on a probe support member and a spacer for maintaining the gap between this external electrode and the potential measuring window at a predetermined distance.

Further, the coil deterioration diagnostic apparatus of the present invention is characterized by comprising: a coil constituted of a conductor to be cooled directly by a medium and an internal electrode mounted in an insulation layer for covering the conductor; a power supply for applying a voltage to the conductor of this coil; a non-contact type surface potentiometer for measuring a potential of the internal electrode through the potential measuring probe; a voltage reading device for measuring a voltage applied from the power supply to the coil; and a calculator for recording and storing a potential measured with the non-contact type surface potentiometer.

Further, the coil deterioration diagnostic apparatus of the present invention is characterized by comprising: a coil constituted of a conductor to be cooled directly by a medium and an internal electrode mounted in an insulation layer for covering the conductor; a power supply for applying a voltage to the conductor of this coil; a surface electrode device mounted on the coil; a non-contact type surface potentiometer for measuring the potential of the surface electrode device through a potential measuring probe; a voltage reading device for measuring a voltage applied from the power supply to the coil; and a calculator for recording and storing a potential measured by the non-contact type surface potentiometer.

According to the coil deterioration diagnostic method and the coil deterioration diagnostic apparatus applicable to the diagnostic method of the present invention, which have the above-described features, the potential of the internal electrode covering the conductor is measured by the non-contact type potentiometer or the high input impedance potentiometer from the outside thereof and it can be discriminated whether the water leaking from the conductor to the insulation layer exists or not on the basis of the measured potential to thereby diagnose the deterioration of the insulation layer. Accordingly, the leaking water to the insulation layer can be detected easily, quickly and securely by the new means which has never utilized in the conventional art.

BRIEF DESCRIPTION OF THE DRAWINGS

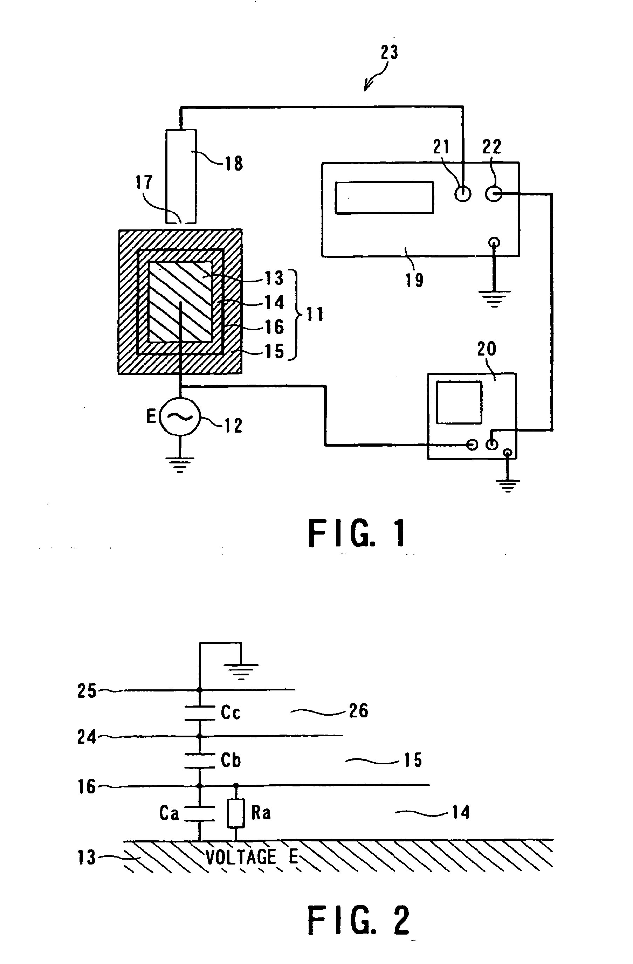

Fig. 1 is a schematic diagram showing a first embodiment of a coil deterioration diagnostic method and a coil deterioration diagnostic apparatus applicable to this diagnostic method according to the present invention.

Fig. 2 is an equivalent electric circuit diagram for calculating a potential of an internal electrode of the first embodiment of the coil deterioration diagnostic method and the coil deterioration diagnostic apparatus applicable to this diagnostic method according to the present invention.

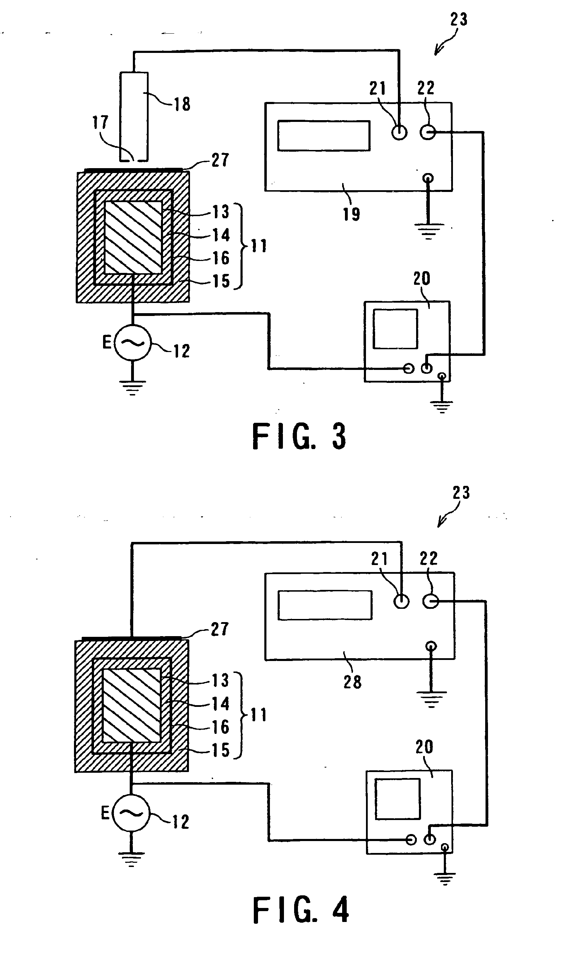

Fig. 3 is a schematic diagram showing a second embodiment of the coil deterioration diagnostic method and coil deterioration diagnostic apparatus applicable to this diagnostic method according to the present invention.

Fig. 4 is a schematic diagram showing a third embodiment of the coil deterioration diagnostic method and coil deterioration diagnostic apparatus applicable to this diagnostic method according to the present invention.

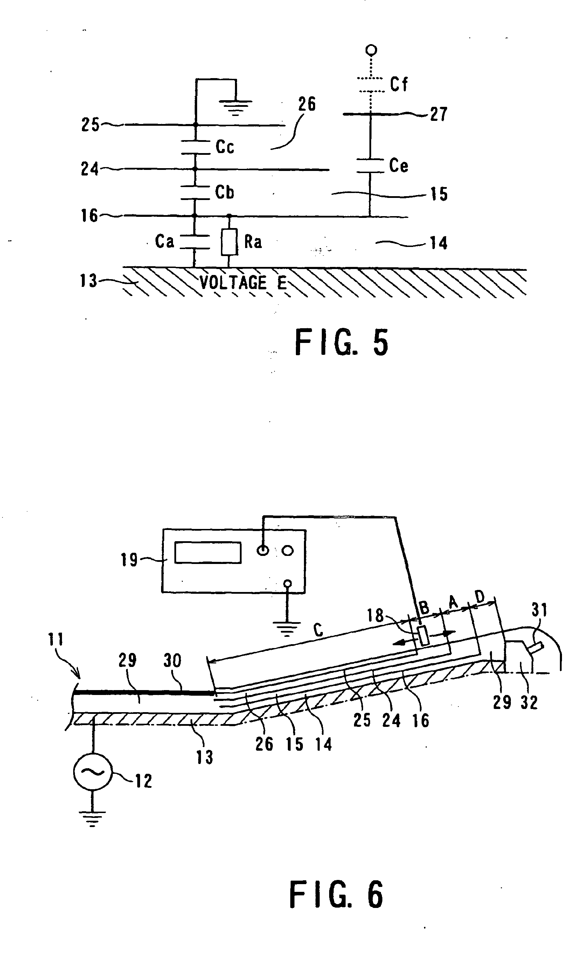

Fig. 5 is an equivalent electric circuit diagram for calculating a potential of an internal electrode of the second embodiment and the third embodiment of the coil deterioration diagnostic method and the coil deterioration diagnostic apparatus applicable to this diagnostic method according to the present invention.

Fig. 6 is a schematic diagram showing a fourth embodiment of the coil deterioration diagnostic method and coil deterioration diagnostic apparatus applicable to this diagnostic method according to the present invention.

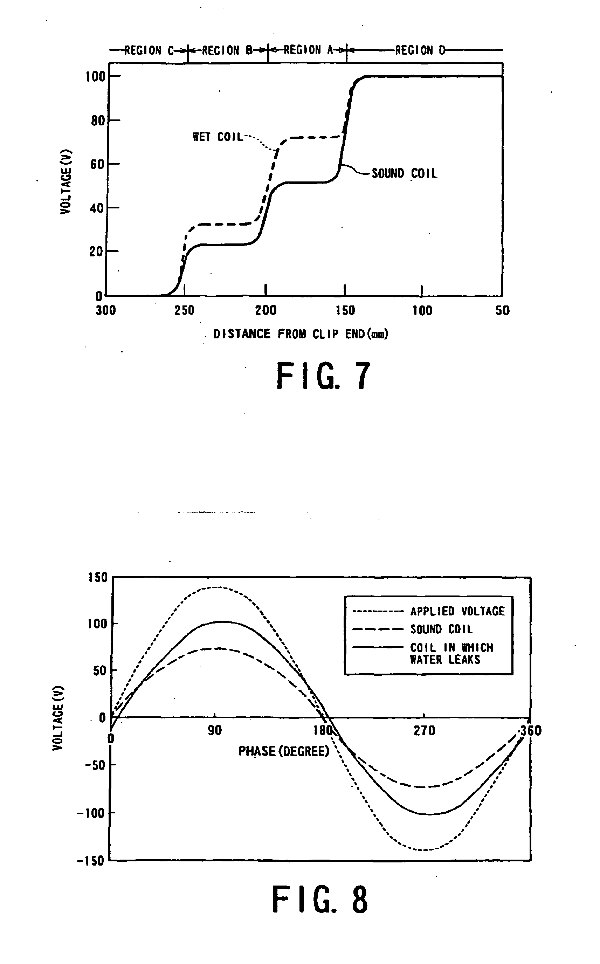

Fig. 7 is a diagram showing changes in surface potential depending on positions in which a potential measured according to the coil deterioration diagnostic method and coil deterioration diagnostic apparatus applicable to this diagnostic method according to the present invention is compared with a potential in a sound coil.

Fig. 8 is a diagram which compares respective waveforms of an applied voltage according to the coil deterioration diagnostic method and coil deterioration diagnostic apparatus applicable to this diagnostic method of the present invention, of a voltage in a sound coil and of a voltage of a coil in which water leaks to its insulation layer.

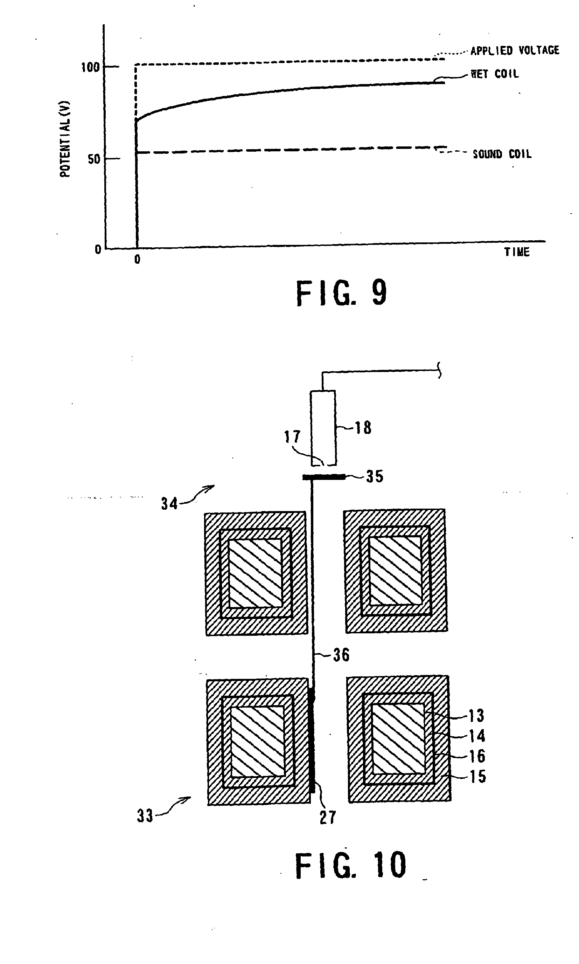

Fig. 9 is a diagram which compares changes in a voltage when stair-step like DC voltage according to the coil deterioration method of the present invention and the coil deterioration diagnostic apparatus applicable to this diagnostic method, in a voltage in a sound coil and in a voltage of a coil in which water leaks to its insulation layer.

Fig. 10 is a schematic diagram showing a fifth embodiment of the coil deterioration diagnostic method and the coil deterioration diagnostic apparatus applicable to this diagnostic method.

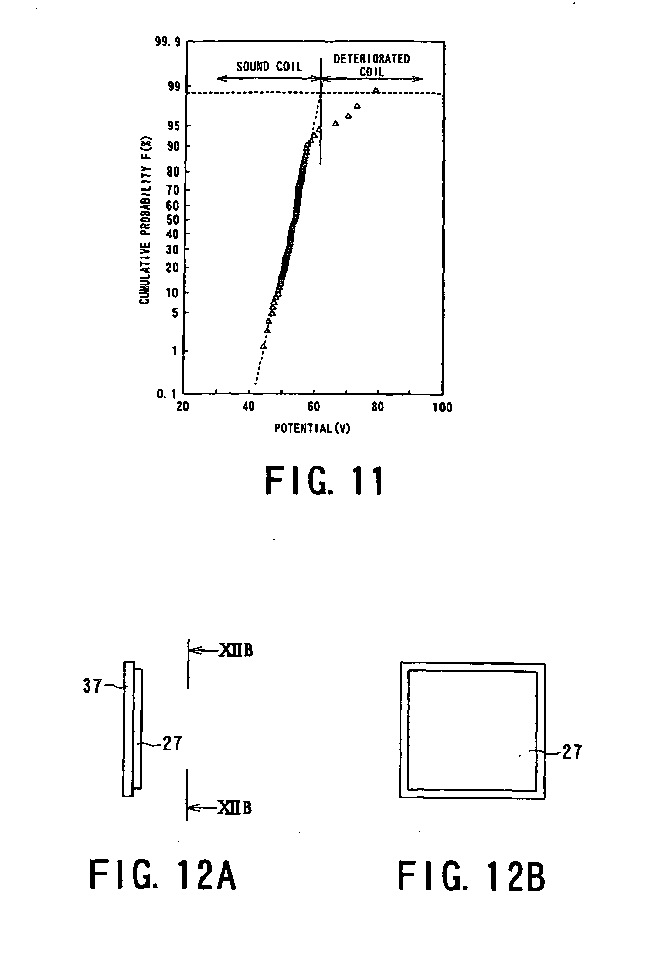

Fig. 11 is a potential probability distribution diagram for determining a sound coil and a deteriorated coil (coil in which water leaks to the insulation layer) according to the coil deterioration diagnostic method of the present invention and the coil deterioration diagnostic apparatus applicable to this diagnostic method.

Fig. 12 is a schematic diagram showing the first example of a surface electrode device applicable to the coil deterioration diagnostic apparatus of the present invention, in which Fig. 12A is a side view of the surface electrode device and Fig. 12B is a front view of the surface electrode device as seen in the direction of an arrow XIIB-XIIB of Fig. 12A.

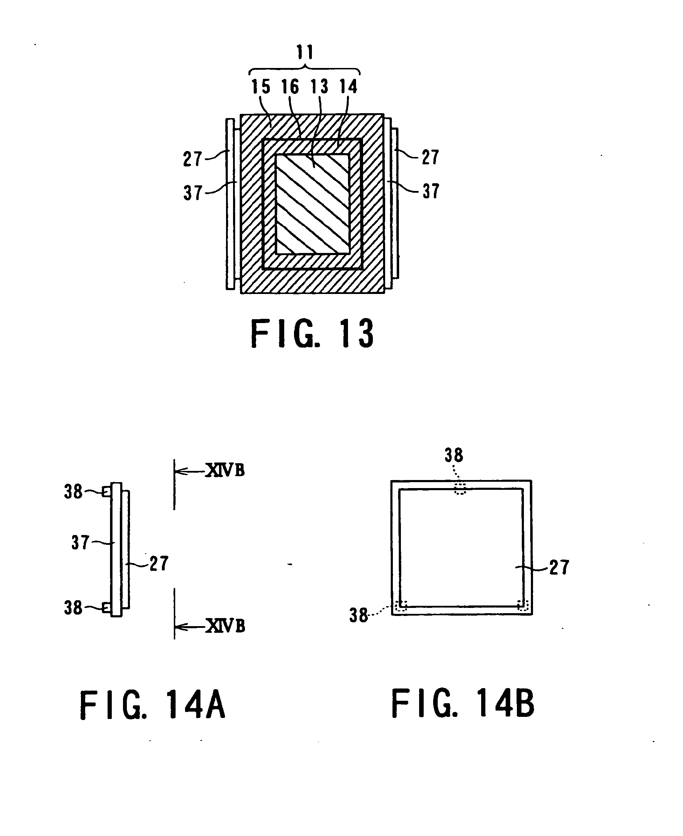

Fig. 13 is a schematic diagram showing a second example of the surface electrode device applicable to the coil deterioration diagnostic apparatus of the present invention.

Fig. 14 is a schematic diagram showing a third example of the surface electrode device applicable to the coil deterioration diagnostic apparatus of the present invention, in which Fig. 14A is a side view of the surface electrode device and Fig. 14B is a front view of the surface electrode device as seen in the direction of an arrow XIVB-XIVB of Fig. 14A.

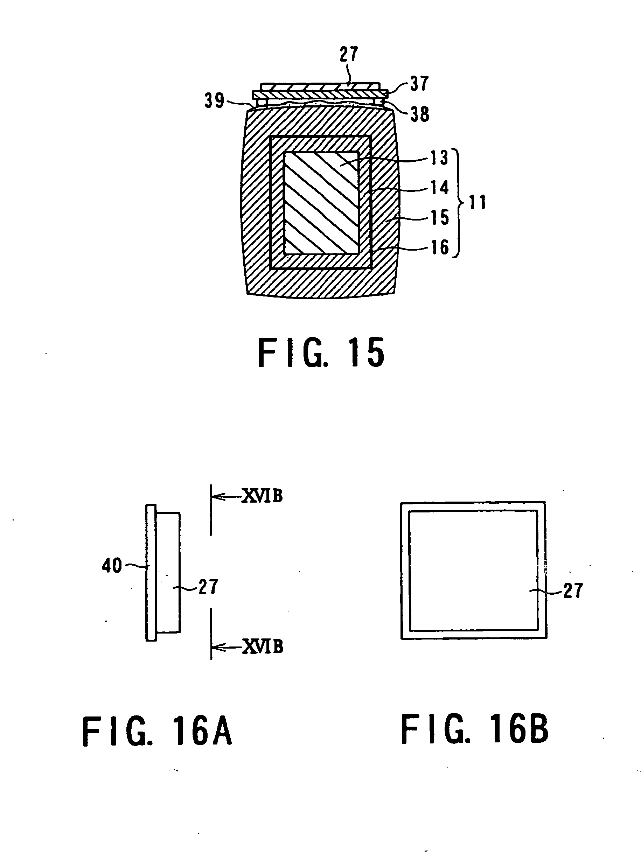

Fig. 15 is a schematic diagram showing a state, mounted on a coil, of the third embodiment of the surface electrode device applicable to the coil deterioration diagnostic apparatus of the present invention.

Fig. 16 is a schematic diagram showing a fourth example of the surface electrode device applicable to the coil deterioration diagnostic apparatus of the present invention, in which Fig. 16A is a side view of the surface electrode device and Fig. 16B is a front view of the surface electrode device as seen in the direction of an arrow XVIB-XVIB of Fig. 16A.

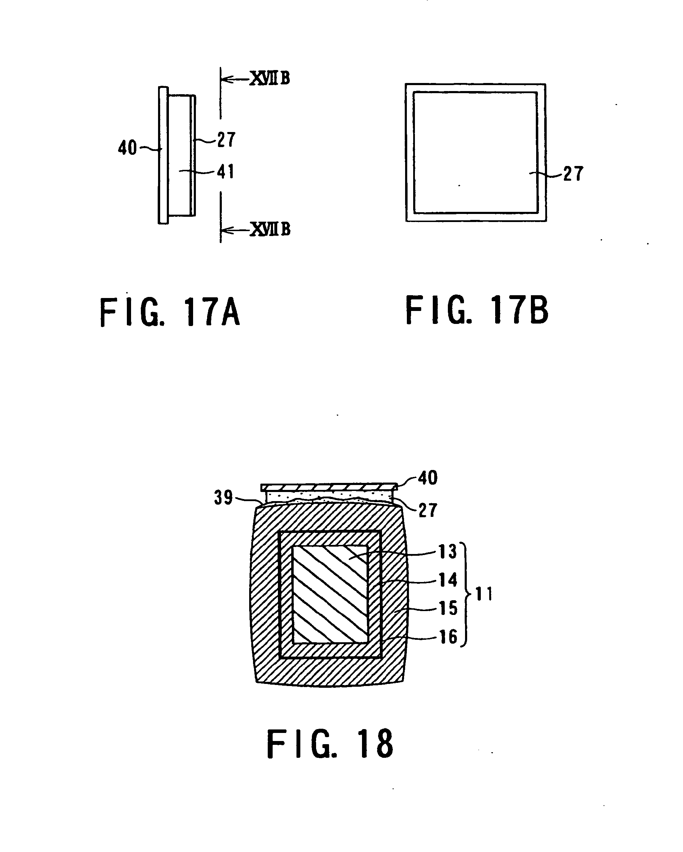

Fig. 17 is a schematic diagram showing a fifth example of the surface electrode device applicable to the coil deterioration diagnostic apparatus of the present invention, in which Fig. 17A is a side view of the surface electrode device and Fig. 17B is a front view of the surface electrode device as seen in the direction of an arrow XVIIB-XVIIB of Fig. 17A.

Fig. 18 is a schematic diagram showing a state, mounted on a coil, of the fourth embodiment of the surface electrode device applicable to the coil deterioration diagnostic apparatus of the present invention.

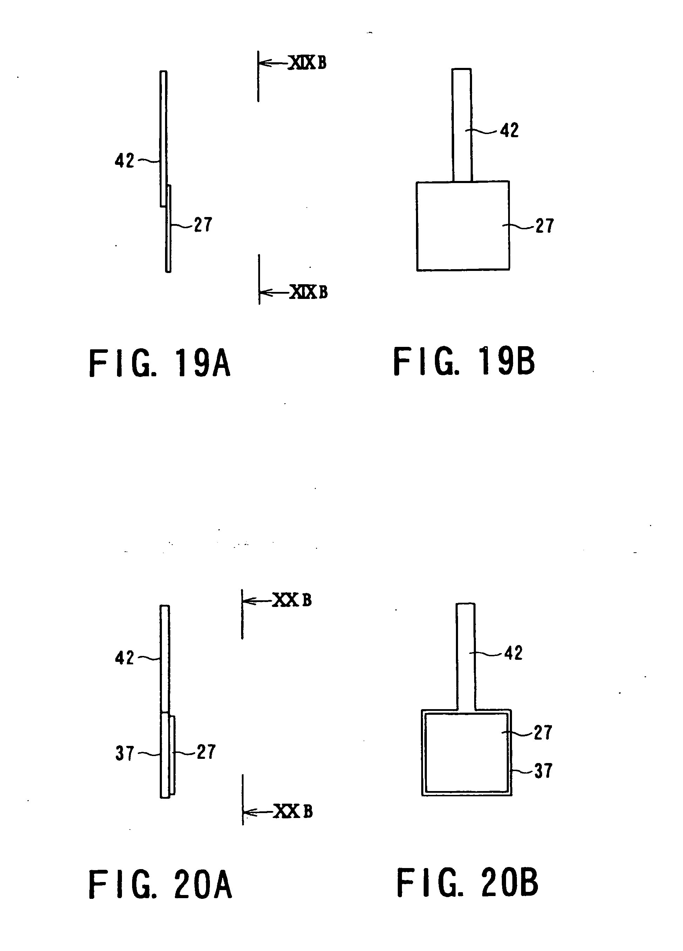

Fig. 19 is a schematic diagram showing a sixth example of the surface electrode device applicable to the coil deterioration diagnostic apparatus of the present invention, in which Fig. 19A is a side view of the surface electrode device and Fig. 19B is a front view of the surface electrode device as seen in the direction of an arrow XIXB-XIXB of Fig. 19A.

Fig. 20 is a schematic diagram showing a seventh example of the surface electrode device applicable to the coil deterioration diagnostic apparatus of the present invention, in which Fig. 20A is a side view of the surface electrode device and Fig. 20B is a front view of the surface electrode device as seen in the direction of an arrow XXB-XXB of Fig. 20A.

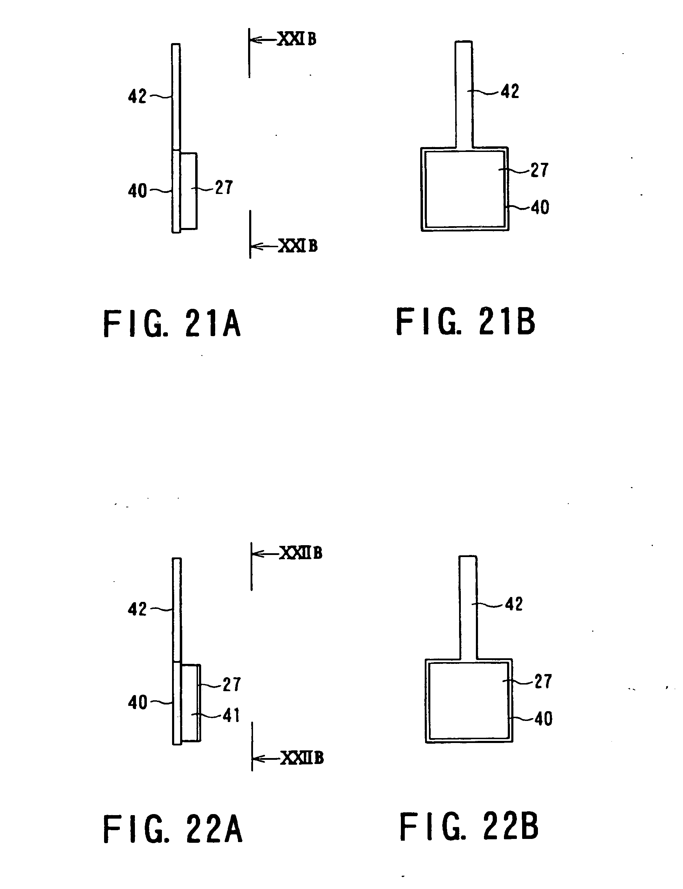

Fig. 21 is a schematic diagram showing an eighth example of the surface electrode device applicable to the coil deterioration diagnostic apparatus of the present invention, in which Fig. 21A is a side view of the surface electrode device and Fig. 21B is a front view of the surface electrode device as seen in the direction of an arrow XXIB-XXIB of Fig. 21A.

Fig. 22 is a schematic diagram showing a ninth example of the surface electrode device applicable to the coil deterioration diagnostic apparatus of the present invention, in which Fig. 22A is a side view of the surface electrode device and Fig. 22B is a front view of the surface electrode device as seen in the direction of an arrow XXIIB-XXIIB of Fig. 22A.

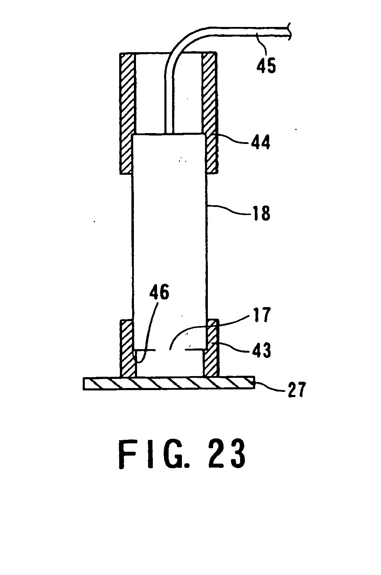

Fig. 23 is a schematic diagram showing a first example of a potential detecting device applicable to the coil deterioration diagnostic apparatus of the present invention.

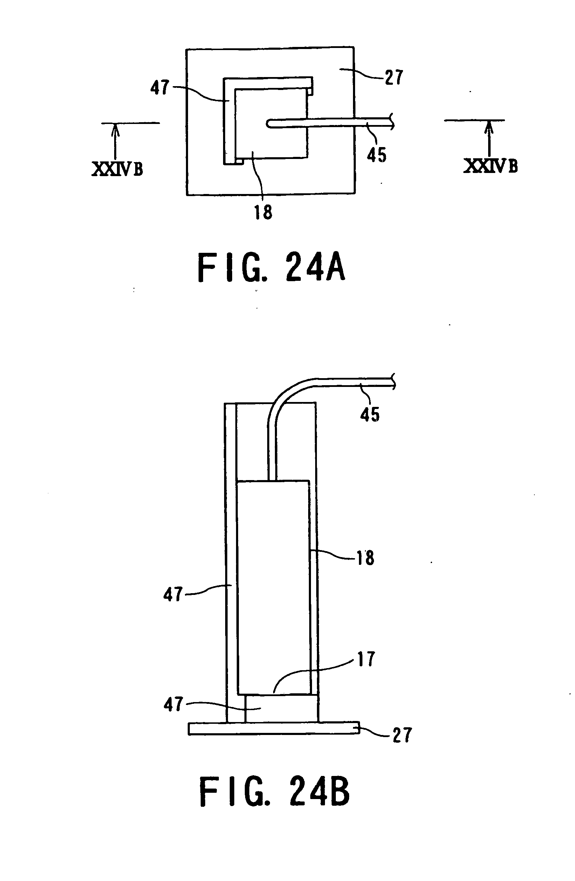

Fig. 24 is a schematic diagram showing a second example of the potential detecting device applicable to the coil deterioration diagnostic apparatus of the present invention, in which Fig. 24A is a plan view of the potential detecting device and Fig. 24B is a sectional view of the potential detecting device taken along the direction of an arrow XXIVB-XXIVB of Fig. 24A.

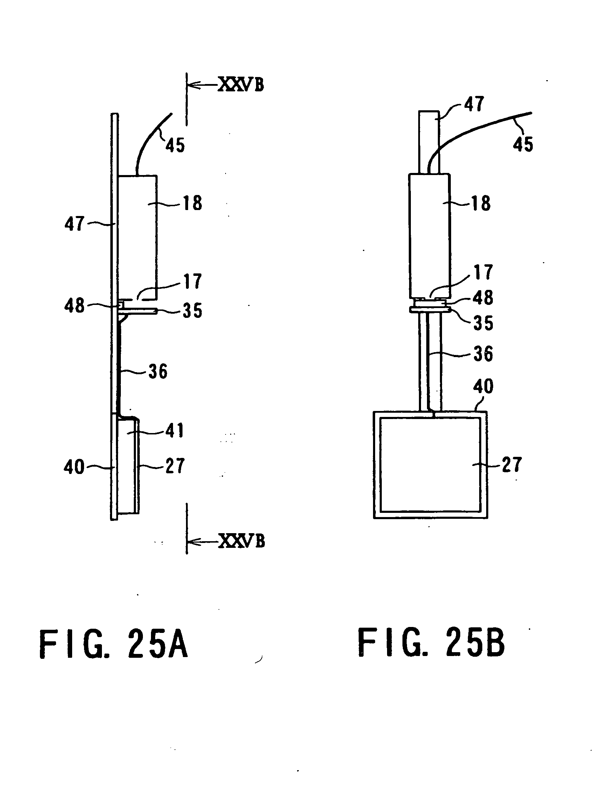

Fig. 25 is a schematic diagram showing a third example of the potential detecting device applicable to the coil deterioration diagnostic apparatus of the present invention, in which Fig. 25A is a side view of the potential detecting device and Fig. 25B is a front view of the potential detecting device as seen in the direction of an arrow XXVB-XXVB of Fig. 25A.

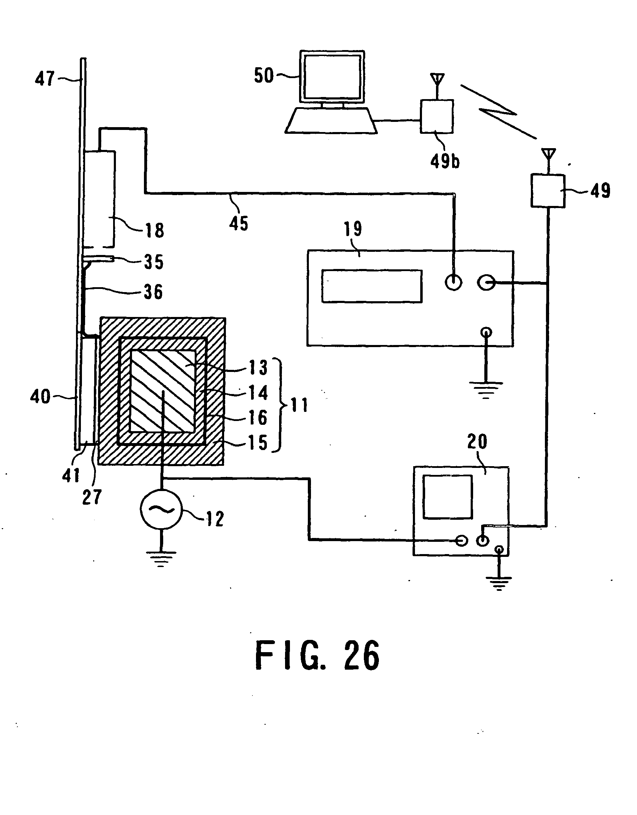

Fig. 26 is a schematic diagram showing a fourth example of the potential detecting device applicable to the coil deterioration diagnostic apparatus of the present invention.

Fig. 27 is a schematic diagram showing a part of a stator coil of a conventional rotating electric machine.

Fig. 28 is a schematic diagram showing a part of an end portion of the stator coil shown in Fig. 27.

BEST MODE FOR CARRYING OUT THE INVENTION

A coil deterioration diagnostic method and a coil deterioration diagnostic apparatus applicable to this diagnostic method according to the present invention will be described hereunder with reference to the accompanying drawings and reference numerals added to those drawings.

Fig. 1 is a schematic diagram showing a first embodiment of the coil deterioration diagnostic method and coil deterioration diagnostic apparatus applicable to this diagnostic method according to the present invention, in which a measuring position is, for example, a lateral sectional position in the region A shown in Fig. 28, which has already mentioned hereinbefore.

The coil deterioration diagnostic apparatus of this embodiment comprises an AC power supply 12 for applying an AC voltage to a coil 11 which is cooled directly with water and a potential measuring device 23 for measuring a potential of the coil 11.

The coil 11 comprises a first insulation layer 14 and a second insulation layer 15 wound around a conductor 13 located at a central portion and a first internal electrode 16 mounted between the first insulation layer 14 and the second insulation layer 15. The lateral sectional portion of this coil 11 corresponds to the region A shown in Fig. 28.

On the other hand, a potential measuring device 23 comprises a potential measuring probe 18 having a potential measuring window 17 at a measuring portion, a non-contact type surface potentiometer 19 connected to the potential measuring probe 18 through an input terminal 21 and adapted to measure a potential of the coil 11 and a voltage reading (read-out) device 20 such as an oscilloscope, an AC voltmeter, connected to the non-contact type surface potentiometer 19 through an output terminal 22 and adapted to measure an AC voltage applied from an AC power supply 12 to the coil 11.

According to the coil deterioration diagnostic method for detecting a potential due to a water leakage from the conductor 13 to the first insulation layer 14 by using the coil deterioration diagnostic apparatus having such a structure as mentioned above, the potential measuring drive window 17 of the potential measuring probe 18 is brought close to one side surface of the coil 11.

First, an AC voltage E is applied to the conductor 13 of the coil 11 from the AC power supply 12. At this time, the potential of the first internal electrode 16 is measured by using the non-contact type surface potentiometer 19 through the potential measuring probe 18, and the voltage thereof is read by the voltage reading device 20. If the AC voltage can be measured by the non-contact type surface potentiometer 19 itself, the voltage reading device 20 may be eliminated.

Then, the potential of the first internal electrode 16 at this time is calculated by utilizing an equivalent circuit shown in Fig. 2.

Now, in the equivalent circuit shown in Fig. 2, it is assumed that an capacitance between the conductor 13 and the first internal electrode 16 located innermost is Ca, an capacitance between the first internal electrode 16 and a second internal electrode 24 is Cb and an capacitance between the second internal electrode 24 and a third internal electrode 25 is Cc.

If leaking water permeates into any one of the first insulation layer 14, the second insulation layer 15 or the third insulation layer 26 from the conductor 13 and relative dielectric constant of water is very large, for example, 80, the capacitance Ca of the first internal electrode 16 increases. Further, it has been well known that if the electric conductivity of water is higher than electric conductivity of the second and third insulation layers 15, 26, dielectric loss increases largely. In order to simulate this dielectric loss, an equivalent resistance Ra is provided between the conductor 13 and the first internal electrode 16. If no leaking water permeates, the voltage E is divided by the capacitances Ca, Cb, Cc.

A potential Va of the first internal electrode 16 is expressed by the following equation.

**[Equation 1]**

$$Va = \frac{1/Cb + 1/Cc}{1/Ca + 1/Cb + 1/Cc}$$

Here, the capacitance Ca between the conductor 13 and the first internal electrode 16, the capacitance Cb between the first internal electrode 16 and the second internal electrode 24, and the capacitance Cc between the second internal electrode 24 and the third internal electrode 25 were given as Ca = 1500 pF, Cb = 2500 pF and Cc = 3000 pF as measured (measuring) values.

Now, in the case of AC of 50 Hz under the applied voltage E of 100 rms, it comes that Va = 52.4 V.

Next, assuming a case that if the leaking water permeates into the first insulation layer 14, and accordingly, the capacitance Ca increases double to 3000 pF, the dielectric loss increases and the electrical loss tangent increases to 0.5 (generally, less than 0.01 if good), the potential Va of the first internal electrode 16 was calculated.

Because of complicated calculation of an equation therefore, only a result of the calculation will be mentioned. It comes that Va = 72.0 V, which is 37% higher than a value of the sound case.

Further, a potential Vb of the second internal electrode 24 was then calculated and Table 1 shows its result.

[Table 1]

| Coil Condition | First Internal Electrode Potential Va(V) | Second Internal Electrode Potential Vb(V) |
|---|---|---|
| Normal | 52.4 | 23.8 |
| Leaking Water Permeation Into Insulation Layer | 72.0 | 32.7 |

According to the Table 1, the potential of the second internal electrode 24 increased by about 37% due to the invasion of the leaking water to the insulation layer.

It was therefore found that the invasion of the leaking water to the insulation layer was firmly related to the increasing of the potential of the internal electrode.

In the meantime, it is necessary for the frequency of an applied voltage to be a frequency which the non-contact type surface potentiometer 19 can follow sufficiently, and in the above example, the frequency of 50 Hz was used.

However, in a case where the frequency response of the non-contact surface potentiometer 19 is lower, that is, lower than a commercial frequency of, for example, 20 Hz, it will be necessary to apply a voltage by using an AC voltage generator.

Further, it is preferable to use an oscilloscope as the voltage reading device 20 in order to determine whether or not the non-contact surface potentiometer 19 sufficiently follows the frequency of an applied voltage to achieve accurate measurement.

According to this embodiment, the AC power supply 12 not always takes a sine wave, and any wave form, which repeatedly changes its form between positive and negative values like a triangular wave, square wave or like, produces the same effect as that mentioned above.

In this way, the present embodiment is capable of quickly and securely detecting the invasion of the leaking water to the insulation layer by measuring the potential of the internal electrode in accordance with the fact that the invasion of the leaking water to the insulation layer is firmly related to the increasing in the potential of the internal electrode, thereby making it possible to surely determine the insulation deterioration.

Fig. 3 is a schematic diagram showing the second embodiment of the coil deterioration diagnostic method and the coil deterioration diagnostic apparatus applicable to the diagnostic method according to the present invention. Further, in this embodiment, the measuring position is also a lateral sectional position in the region A shown in Fig. 28 like the first embodiment.

Same reference numerals are attached to the same components as those used in the first embodiment.

The coil deterioration diagnostic apparatus of this second embodiment is prepared by utilizing the surface electrode 27 which is mounted on the surface of the second insulation layer 15.

The surface electrode 27 is produced by coating one side surface of, for example, a 30 x 30 mm aluminum foil with an adhesive agent and then bonding it to an outside surface of the second insulation layer 15. Further, other components are substantially the same as those of the first embodiment, so that a description thereof is omitted herein.

The coil deterioration diagnostic method for detecting a potential caused by water leaking from the conductor 13 to the first insulation layer 14 is carried out by using the coil deterioration diagnostic apparatus having such a structure as mentioned above in a manner that the potential measuring window 17 of the potential measuring probe 18 is brought close to the surface electrode 27 attached to the outside surface of the second insulation layer 15, the AC voltage E is applied to the conductor 13 of the coil 11 from the AC power supply 12 and the potential of the surface electrode 27 is measured by using the non-contact type surface potentiometer 19 through the potential measuring probe 18 while reading out the voltage with the voltage reading (read-out) device 20.

If the AC voltage can be measured with the non-contact type surface potentiometer 19, the voltage reading device 20 may be omitted as in the first embodiment. When the potential of the surface electrode 27 is measured, it is permissible to employ a high input impedance potentiometer 28 in place of the voltage measuring probe 18 and the non-contact type surface potentiometer 19 used under the first embodiment as shown in Fig. 4.

Next, the potential of the surface electrode 27 is calculated by using the equivalent circuit shown in Fig. 5.

The equivalent circuit shown in Fig. 5 is constructed by adding an capacitance Ce between the first internal electrode 16 and the surface electrode 27 and a stray capacitance Cf between the surface electrode 27 and a surrounding coil to the equivalent circuit as that in the first embodiment shown in Fig. 2.

The potential of the surface electrode 27 is referred to as a potential gained by dividing the potential of the first internal electrode 16 and the potential of the surrounding component with the stray capacitance Cf and the capacitance Ce. Here, the capacitance Ce is sufficiently larger than the stray capacitance Cf and the potential of the surface electrode 27 is different from the potential of the first internal electrode 16 by an amount of less than several percentages. Thus, the potential of the surface electrode 27 could be regarded as the potential of the first internal electrode 16.

According to this embodiment, it is focused that the potential of the surface electrode 27 can be regarded as the potential of the first internal electrode 16 and can detect quickly and securely the invasion of the leaking water to the insulation layer by measuring the potential of the surface electrode 27 to thereby accurately determine insulation deterioration.

Fig. 6 is a schematic diagram representing the fourth embodiment of the coil deterioration diagnostic method and the coil deterioration diagnostic apparatus applicable to this diagnostic method according to the present invention.

In Fig. 6, the same reference numerals are attached to the same components as those used for the first embodiment.

The outside of the conductor 13 of the coil 11 including the top coil and the bottom coil is covered with the insulation layer 29 and the first to third insulation layers 14, 15, 26. The first to third internal electrodes 16, 24, 25 are mounted on the insulation layer 29 and the first to third insulation layers 14, 15, 26. The third internal electrode 25 on the outermost layer is connected to a low resistance layer 30 on the outermost layer of a straight line portion of the coil 11, and the capacitance of the first to third insulation layers 14, 15, 26 is divided by the first and second internal electrodes 16, 24 at the intermediate position. Further, the positions of the first to third internal electrodes 16, 24, 25 cannot be observed from the outside in a rotating electric machine having a coil insulated structure in which an electric field on an outside surface of the insulation layer at the coil end portion is suppressed to be small. Therefore, according to this embodiment, after the positions of the first to third internal electrodes 16, 24, 25 are confirmed, the potential of the internal electrode is measured to determine whether the invasion of the water leaking from the conductor 13 to the first to third insulation layers 14, 15, 26 occurs, or not. An end of a coil end portion is provided with a clip 32 having a pipe 31 for directly cooling the conductor 13 with water. For the sake of easy explanation, among the insulation layer 29 and the first to third insulation layers 14, 15, 26 of the coil 11, the region A is called a first internal electrode space region, the region B is called a second internal electrode space region, and the region C is called a third internal electrode space region and the region D is called an internal electrode non-existing region for discrimination.

According to this embodiment, an AC voltage is applied to the conductor 13 from the AC power supply 12, and then the potential measuring probe 18 of the non-contact type surface potentiometer 19 is advanced or retracted along the surface of the coil end portion so as to measure potentials at the regions A to D.

Fig. 7 is a diagram of potential of a comparison between the potential of a coil undergoing leaking water (indicated with dotted line) and potential of a sound coil (indicated with solid line) as a result of advancing or retracting the potential measuring probe 18 of the non-contact surface type potentiometer 19 along the surface of the coil end portion.

As shown in Fig. 7, it was found that the potential changes relatively clearly in step by step as the potential measuring probe 18 is advanced or retracted over the regions A to D. As for the potential of the first internal electrode 16 and the second internal electrode 24, if a potential in the region 160 mm to 190 mm from the clip 32 or a potential in the region 210 mm to 240 mm from the clip 32 is read, respectively, the fact whether or not water leakage is caused can be determined in comparison with the sound coil.

As mentioned above, according to this embodiment, the potentials of the regions A, B in the respective internal electrodes 16, 24 are measured after the positions of the first and second internal electrodes 16, 24 have been confirmed by advancing or retracting the potential measuring probe 18 along the outer surface of the insulation layer, and the fact whether the leaking water is absent or present can be discriminated according to the measurement result. Thus, the invasion of the leaking water into the insulation layer can be detected easily and quickly and the insulation deterioration can be hence recognized quickly to take an appropriate countermeasure thereafter.

Although according to this embodiment, the potentials of the regions A and B of the respective internal electrodes 16, 24 are measured after the positions of the first and second internal electrodes 16, 24 are confirmed by advancing or retracting the potential measuring probe 18 along the outer surface of the insulation layer, it may be permissible to mount the surface electrode 27 on a measuring position at the potential measurement time and to measure the potential of the surface electrode 27 by using either one of the non-contact type surface potentiometer 19 or the high input impedance potentiometer 28.

Furthermore, upon detection of the invasion of the water leaking from the conductor 13 to the insulation layer, it may be permissible to observe potential waveforms of the first internal electrode 16 and the second internal electrode 24 measured according to the embodiment shown in Fig. 1 or the second embodiment shown in Fig. 3 and to read a phase difference of the potential waveform relative to an applied voltage to determine whether or not the water leaking to the insulation layer is caused by the phase difference.

That is, when an AC voltage of, for example, 100 Vrms is applied to the conductor 13, the potential waveform of the internal electrode of a sound coil is expressed in the sine-wave curve of the same phase as the applied voltage indicated with a narrow dotted line and, on the other hand, the potential waveform of the internal electrode of a coil when the leaking water permeates into the insulation layer is expressed in a sine-wave curve indicated with solid line with its phase being delayed.

Thus, this embodiment utilizes a phenomenon that if the leaking water permeates into the insulation layer, the phase is delayed as compared with the potential waveform of the sound coil.

As mentioned above, this embodiment determines that the leaking water permeates into the insulation layer at a time when a measured potential waveform is delayed as compared with a potential waveform of the sound coil, so that it can be easily recognized whether the leaking water exists or not, and therefore, an appropriate countermeasure can be surely taken.

Upon the detection of the invasion of the water leaking from the conductor 13 to the insulation layer, it may be permissible to determine the presence or absence of the leaking water by shaping a DC voltage to be applied to the conductor 13 into a stepwise form or a square waveform. For example, according to an experiment, it was found that when a DC voltage of 100 V having a stepwise waveform was applied to the conductor 13, the potential of the first internal electrode 16 became about 52 V as indicated with dotted line and, after that, although a constant value was maintained, a coil undergoing water leakage rose to about 72 V immediately after the voltage was applied as indicated with solid line and then further rose slightly with time.

This embodiment advantageously utilizes the phenomenon that when the leaking water permeates into the insulation layer, the potential rises more than that of a sound coil.

As described above, according to this embodiment, the DC voltage is applied to the conductor 13, and thereafter, the potential of the first internal electrode 16 is readout, and accordingly, when the potential becomes higher than that of the sound coil, the leakage of water into the insulation layer can be determined. Thus, the invasion of the leaking water into the insulation layer can be detected easily and quickly, so that insulation deterioration can be recognized early and an appropriate countermeasure can be taken.

Further, when the surface electrode 27 is attached onto the outer surface of the insulation layer to detect the invasion of the water leaking from the conductor 13 to the insulation layer, the outer surface of the insulation layer is charged by friction or the like, so that even when zero voltage is applied, the first electrode 27 may have a large potential, which may cause an error in measurement. For this reason, before a voltage is applied to the conductor 13, the surface electrode 27 is once grounded and then released. Then, a voltage is applied to the conductor 13 and the potential of the first internal electrode 16 is read out. In this time, when a measured value is higher than the potential of a sound coil, it can be considered that the leaking water permeates into the insulation layer. Accordingly, the presence or absence of the invasion of the leaking water into the insulation layer can be determined with a small measurement error.

Fig. 10 is a schematic diagram representing the fifth embodiment of the coil deterioration diagnostic method and coil deterioration diagnostic apparatus applicable to this diagnostic method according to the present invention.

Same reference numerals are attached to the same components as those used for the first embodiment.

In the coil deterioration diagnostic apparatus of this embodiment, the surface electrode 27 is attached to the second insulation layer 15 of an outer diameter side coil (bottom coil) 33 and an external (outer) electrode 35 is provided on the inner diameter side of an inner diameter side coil (top coil) 34. The surface electrode 27 is connected to the external electrode 35 with a connecting wire 36 so that the surface electrode 27 and the external electrode 35 come to have the same potential. When detecting whether or not leaking water permeates into the insulation layer, the potential measuring probe 18 having the potential measuring window 17 is brought close the external electrode 35 so as to measure the potential of the surface electrode 27, which is of the same potential as the external electrode 35, thereby enabling a portion whose potential cannot be measured directly to easily undergo the measurement of the potential. Since the surface electrode 27 and the external electrode 35 are of the same potential in terms of an electric circuit, in a case that they are integrally replaced with the surface electrode 27, this embodiment will be explained with reference to Fig. 5.

In this case, when measuring the electricity of the external electrode 35, it is necessary to sufficiently decrease the capacitances between the surf ace electrode 27, the external electrode 35, the connecting wire 36 and a surrounding coil. That is, it is necessary to make the capacitance Cf sufficiently smaller than the capacitance Ce in Fig. 5 while maintaining the insulation resistance sufficiently high so as to decrease the measurement error.

In the embodiments described hereinbefore, the surface electrode 27 and the external electrode 35 can be composed of any material which has a conductivity such as fiber reinforced plastic (FRP), produced by bonding metal, conductive polymeric material, and conductive fiber and may be formed in a polygonal, circular, oval shape or like shape.

The coil deterioration diagnostic method for detecting a potential of the first internal electrode 16 based on the water leaking from the conductor 13 to the first insulation layer 14 using the coil deterioration diagnostic apparatus having such a structure as mentioned above will be described with reference to Fig. 11.

Data for the measurement of the potential of the first internal electrode 16 includes an insulation thickness of a manufactured coil, dispersion of a length of the first internal electrode 16, installation conditions of the surface electrode 27 and external electrode 35, dispersion of a positional relation between the potential measuring probe 18 and a measuring electrode, and a measurement error by a measuring person. According to this embodiment, the measurement data is subjected to statistical consideration to thereby determine whether it is a sound coil or a coil undergoing the invasion of the leaking water.

Fig. 11 indicates 84 points obtained by measurement of 42 end portions on the turbine side and the collector side on the inner diameter side coil (top coil) 34, which are plotted on a normal probability paper.

In order to obtain the probability, an average rank method is employed and the plotting is made under 1/(84 + 1) = 1.2% to 84/(84 + 1) = 98.8%. The five points of more than 94% in the probability are largely off from a regression line of the data points as the sound coil.

Considering in terms of probability, it is appropriate to consider that, with an intersection between the regression line and the dotted line indicating maximum probability of 98.8% as a limit value, data larger than this maximum probability is off from the distribution of the sound coils. In the example mentioned above, four points are off from the regression line, so that it is determined that these four points indicate the insulation layers subjected to the invasion of the leaking water.

As another coil deterioration diagnostic method, a method simpler than the above-described coil deterioration diagnostic method is available.

According to this coil deterioration diagnostic method, an average value and a standard deviation of measurement data are obtained and a value obtained by adding a product between the standard deviation and a predetermined multiple "A" to the average value is regarded as a limit value, and data exceeding this value is considered to be off from the data distribution of the sound coils, so that it is determined that leaking water permeates into the insulation layer.

The above matter will be explained in detail by using the data shown in Fig. 11. The average value of the data is 53.59 and the standard deviation is 5.32. As the multiple "A", usually, 2.5 times or 3.0 times is often used.

If the multiple is 2.5 times, the limit value is 53.59 + 2.5 x 5.32 = 66.89.

If the multiple is 3.0 times, the limit value is 53.59 + 3.0 x 5.32 = 69.55.

Even in the adoption of either one of the above multiples, according to this data, three points are off, and therefore, these three points are determined to indicate the insulation layers undergoing the invasion of the leaking water.

Depending on a statistical processing method, the number of coils for determining that the leaking water permeates into the insulation layer may be different from the actual number of coils. Although countermeasures may be different in accordance with situations, in a case that the safeness is considered, the lower limit value should be adopted.

According to the above-described method, although it may be considered that the diagnosis of the deterioration in the coil can be easily done for all the coils by measuring the potential of the internal electrode, actually, this is not always true.

For example, in order to suppress the vibration of the coils due to electromagnetic force, the coil end portion is wound up with glass string, nipped with fiber reinforced plastic (FRP) block or tightened by a bolt, so that the internal electrode 16 or 24 may not be sometimes measured at the same position (region A or region B indicated in Fig. 6) . Because of this reason, there is a case that the potential measurement of the first internal electrode 16 in the region A and the potential measurement of the second internal electrode 24 in the region Bmay coexist.

In such a case, the ratio of potential between the first internal electrode 16 and the second internal electrode 24 is determined depending on the geometric shape of the internal electrode as already shown in the Table 1, this ratio does not give any influence to the invasion of the leaking water into the first insulation layer 14. In the case of the data indicated in the Table 1, the ratio of potential between the first internal electrode 16 and the second internal electrode 24 is 2.2 times for both the sound coil and the coil undergoing the invasion of the leaking water to the insulation layer.

Therefore, the above-mentioned problem can be solved by using a coil which enables the potentials of both the electrodes to be measured so as to preliminarily obtain the ratio of the potential between both the electrodes is obtained preliminarily and by using the data converted to the potential of either one of the first internal electrode 16 or the second internal electrode 24. Thus, it can be detected whether the leaking water permeates into the insulation layer or not.

Figs. 12A and 12B are schematic views showing the first example of the surface electrode device applied to the coil deterioration diagnostic apparatus of the present invention, in which Fig. 12A is a side view of the surface electrode device and Fig. 12B is a front view thereof as viewed in the direction of an arrow of XIIB-XIIB of Fig. 12A.

In the surface electrode device of this example, an insulation plate 37 is bonded to the surface electrode 27 made of any one of a conductive plate, film or foil.

According to this embodiment, although the insulation plate 37 is bonded to the surface electrode 27 so as to prepare a surface electrode device, it may be permissible to bond the surface electrode 27 composed of anyone of the conductive plate, film or foil together with the insulation plate 37 in a so-called sandwich shape. For example, as shown in Fig. 13, it may be permissible to bond a surface electrode device in which the surface electrode 27 and the insulation plate 37 are disposed in this order outward on one side surface of the coil 11 in which the conductor 13 is covered with the first insulation layer 14 and the second insulation layer 15, and on the other hand, the first internal electrode 16 is disposed between the first insulation layer 14 and the second insulation layer 15 or a surface electrode device in which the insulation plate 37 and the surface electrode 27 are disposed in this order outward as shown on the other side surface of the coil 11. The reason why the measurement can be done even if the bonding order is inverted resides in that an influence of electrification on an insulation substance can be removed because an AC, a step-like DC or a square waveform voltage is applied by using the non-contact type surface potential measuring device so as to measure a change rate.

Even if there is a gap of less than about 1 mm between the surface electrode device and the surface of the coil, no influence is applied to the potential measurement accuracy in the case of no change in gap length.

Figs. 14A and 14B are schematic views showing the third example of the surface electrode device applied to the coil deterioration diagnostic apparatus of the present invention, in which Fig. 14A is a side view of the surface electrode device and Fig. 14B is a front view thereof as viewed in the direction of an arrow XIVB-XIVB of Fig. 14A.

The surface electrode device of this example is produced by bonding the surface electrode 27 on the insulation plate 37 having a plurality of protrusions 38.

In general, an error occurs in measurement of the potential because the coil end portion has a curved or uneven surface.

According to this example, this matter is taken into consideration, and when the surface electrode 27 is attached to the surface of the coil 11 as shown in Fig. 15, even if an unevenness is caused due to a treatment of a varnish 29 on the surface of the coil 11, its stability is secured by the protrusions formed on the insulation plate 37, so that a change in the distance between the first internal electrode 16 and the surface electrode 27 can be made small, thereby reducing the error in measurement of the potential.

Therefore, according to this example, since the change in the distance between the first internal electrode 16 and the surface electrode 27 is reduced, the measurement of the potential can be done with a small measurement error.

Figs. 16A and 16B are schematic views showing the fourth example of the surface electrode device applied to the coil deterioration diagnostic apparatus of the present invention, in which Fig. 16A is a side view of the surface electrode device and Fig. 16B is a front view thereof as viewed in the direction of an arrow XVIB-XVIB of Fig. 16A.

In the surface electrode device of this example, the surface electrode 27 formed of conductive material such as conductive sponge and conductive rubber is bonded to a pressing plate 40 formed of a material having an excellent insulation characteristic or conductivity.

According to this example, the surface electrode device is produced by bonding the pressing plate 40 to the surface electrode 27 composed of a conductive material, and this surface conductive device is bonded to the surface of the coil 11 as shown in Fig. 18. At this time, even if there is an unevenness caused through the treatment of the vanish 29 on the surface of the coil 11, an adhesion property can be maintained by giving a thrust pressure from the pressing plate 40 utilizing a cushioning effect of the surface electrode 27 formed of a conductive material, following such unevenness, so that the change in the distance between the first internal electrode 16 and the surface electrode 27 can be made small, thereby reducing the potential measurement error. According to this embodiment, although the pressing plate 40 is bonded to the surface electrode 27 formed of the conductive material, in place of this example, it may be permissible to impose an elastic or flexible member 41 having an excellent cushioning performance between the surface electrode 27 formed of the conductive material and the pressing plate 40 as shown in Figs. 17A and 17B.

Figs. 19A and 19B are schematic views showing the sixth example of the surface electrode device applied to the coil deterioration diagnostic method of the present invention, in which Fig. 19A is a side view of the surface electrode device and Fig. 19B is a front view thereof as viewed in the direction of an arrow XIXB-XIXB of Fig. 19A.

In the surface electrode device of this example, since the surface electrode 27 is provided with a handle 42, it is convenient for carrying the surface electrode 27 and for maintaining a thrust pressure of the surface electrode 27 onto a measuring position of the coil 11.

According to this example, although the surface electrode 27 is provided with the handle 42, the present invention is not limited to this example, and it may be permissible to attach or mount the handle 42 respectively to, for example, the insulation plate 37 bonded to the surface electrode 27 as shown in Figs. 20A and 20B, the pressing plate 40 bonded to the surface electrode 27 formed of a conductive material as shown in Figs. 21A and 21B, and the pressing plate 40 bonded to the surface electrode 27 formed of a conductive material as shown in Fig. 22A and 22B through the elastic member 41.

An attaching or mounting angle of the handle 42 shown in Figs. 19 to 22 can be adjusted freely so as to enhance easy operating thereof.

Furthermore, in Figs. 12 to 17 and Figs. 20 to 22, the insulation plate 37 and the pressing plate 4 0 are used for holding the surface electrode 27 and a single or plural holes may be formed to each of these plates. Further, in the case that the surface electrode 27 is formed of a solid material, the insulation plate 37 and the pressing plate 40 may be constructed as only frames.

Fig. 23 is a schematic view showing the first example of a potential detecting device applied to the coil deterioration diagnostic apparatus according to the present invention.

Further, the same reference numerals are attached to the same components as those used for the first embodiment.

In the potential detecting device of this example, a probe support member 43 formed of an insulation material is mounted on the surface electrode 27, and the potential measuring window 17 of the potential measuring probe 18 is mounted on this probe support member 43. A probe holding device 44 formed of an insulation material is also mounted to a portion opposing to the potential measuring window 17 of the electronic measuring probe 18.

The probe support member 43 has a step (staged) portion 46 and the potential measuring probe 18 is supported by this step portion 46 so as to maintain a gap, at a constant distance, between the potential measuring window 17 of the potential measuring probe 18 and the surface electrode 27.

Furthermore, the potential measuring probe 18 is connected to the non-contact surface potentiometer (not shown) through a probe lead wire 45 passing the probe holding device 44.

According to the potential detecting device having such a structure as mentioned above, first, the probe holding device 44 is carried with the hand to measure a potential and the surface electrode 27 is then moved along the surface of a coil (not shown) so as to measure the surface potential. The measuring position (or position to be measured) is recognized depending on a changing condition of the potential shown in Fig. 7, and the surface electrode 27 is brought into a contact with this measuring position so as to measure the potential of the internal electrode of the coil.

As mentioned above, according to this example; upon measuring of the potential of the internal electrode of a coil, since the procedure for mounting the potential measuring probe 18 on the surface electrode 27 can be carried out by an operator with a single hand by disposing the probe support member 43 and the probe holding device 44 for the potential measuring probe 18, the measuring work can be simplified.

Further, according to this example, although the probe support member 43 and the probe holding device 44 are mounted at separate positions of the potential measuring probe 18, the present invention is not limited to such arrangement of this example, and as shown in Figs. 24A and 24B, it may be permissible to support the potential measuring probe 18 with a probe support member 47 having an L-shaped integrated configuration.

Figs. 25A and 25B are schematic views showing the third example of the potential detecting device applied to the coil deterioration diagnostic apparatus of the present invention, in which Fig. 25A is a side view of the potential detecting device and Fig. 25B is a front view thereof as viewed in the direction of an arrow XXVB-XXVB of Fig. 25A.

Further, the same reference numerals are attached to the same components as those used for the first embodiment.

According to the potential detecting device of this embodiment, the surface electrode 27 formed of a conductive material is bonded to the pressing plate 40 through the elastic member 41 and the external electrode 35 and the potential measuring probe 18 are provided on the probe support member 47 extending from the pressing plate 40. Then, the surface electrode 27 and the external electrode 35 are connected together through a connecting wire 36 and a spacer 48 is interposed among the external electrode 35, the potential measuring probe 18a and the potential measuring window 17. The potential measuring probe 18 is connected to a non-contact type surface potentiometer (not shown) through a probe lead wire 45.

As mentioned, in this example, the surface electrode 27, the external electrode 35, and the potential measuring probe 18 are integrally mounted to the pressing plate 40 and the probe supporting device 47, the preliminary setup and installation thereof on the coil can be simplified, thus further improving the working efficiency. Particularly, at a time when the potential at a portion to which the coil does not directly approaches is measured, the installation , carriage and the like working can be effectively done.

As the electrode portion coming into contact with the surface of the coil mentioned with reference to Figs. 23 to 25, it may be permissible to use the electrode device shown in Fig. 12, 13, 14, 16 or 17 instead of the one described in this example.

Fig. 26 is a schematic diagram showing the fourth example of the potential detecting device applied to the coil deterioration diagnostic apparatus of the present invention, in which the same reference numerals are attached to the same components as those used in the first embodiment.

According to the potential detecting device of this example, as in the example shown in Fig. 25, the probe lead wire 45, the external electrode 35, the potential measuring probe 18, and the like are mounted on the probe support member 47 extending from the pressing plate 40 bonded to the surface electrode 27 through the elastic member 41, so that the surface electrode 27, the external electrode 35, the potential measuring probe 18 and the like are installed as integral structure to thereby facilitate the carriage or transport thereof. Furthermore, in the potential detecting device, the conductor 13 is come into contact with the first insulation layer 14 and the second insulation layer 15, and on the other hand, the surface electrode 27 is come into contact with the coil 11 covered with the first internal electrode 16. The potential of the first internal electrode 16 is measured by the potential measuring probe 18, the measured potential is inputted in the computer or calculator 50 through transmitting/receiving elements 49a, 49b to store the data.

In the meantime, this example is provided with the voltage reading device 20 for reading the size and the waveform of the AC voltage E to be applied from the AC power supply to the conductor 13.

Thus, according to this example, the surface electrode 27, the external electrode 35, and the potential measuring probe 18 are mounted on the pressing plate 40 and the probe support member 47 so as to provide an integrated structure, thus facilitating the installation and carriage thereof. In addition, since the potential measured by the potential measuring probe 18 is stored in a computer 50, a subsequent coil deterioration measure based on the data can be carried out more accurately. Further, according to this example, although the non-contact type surface potentiometer 19 and the computer 50 are connected by means of the electric wave, the present invention is not limited to this example, and it may be permissible to be connect by means of infrared ray or directly connected by using a signal connection cable.

INDUSTRIAL APPLICABILITY

According to the coil deterioration diagnostic method and the coil deterioration diagnostic apparatus applicable to this diagnostic method of the present invention, the potential of an internal electrode which covers the conductor is measured by a non-contact type potentiometer or a high input impedance potentiometer from an outside portion, and it is diagnosed whether the water leaking from the conductor to the insulation layer exists or not on the basis of the measured potential and the deterioration of the insulation layer is thus diagnosed. Accordingly, the leaking water to the insulation layer can be detected easily, quickly, and securely by utilizing new means never conceived in the conventional art, and the subsequent treatment can be carried out accurately. Therefore, the present invention can be highly advantageous for the industrial applicability.

**Claims**

1. A coil deterioration diagnostic method, wherein a conductor to be cooled directly by a medium is covered with an insulation layer (14, 15), a coil (11) is constituted of the conductor (13) and internal electrodes (16) to be wrapped in the insulation layer, an AC voltage (12) is applied to the conductor of the coil, and a potential of the internal electrode or potentials of the internal electrodes are measured by a potential measuring probe (18) facing the coil, and wherein if a measured potential is higher than the potential of a sound coil, it is discriminated that the medium leaks out from the conductor to the insulation layer and an insulation thereof is deteriorated.

2. The coil deterioration diagnostic method according to claim 1, wherein if the measured potential of the internal electrode or has a difference in phase with respect to a voltage applied to the conductor from the phase of a sound coil, it is discriminated that medium leaks out from the conductor to the insulation layer and the insulation thereof is deteriorated.

3. The coil deterioration diagnostic method according to claim 1, wherein when the measured potential exceeds a limit value obtained by statistical processing, it is discriminated that the medium leaks out from the conductor to the insulation layer and the insulation is deteriorated.

4. The coil deterioration diagnostic method according to claim 1, wherein when the measured potentials differ depending on positions of the internal electrode, a standard value for a ratio of the potential of the internal electrode having a different potential is preliminarily obtained and thereafter converted to a potential of the internal electrode at the same position.

5. The coil deterioration diagnostic method according to claim 1, wherein the AC voltage is represented by a since-wave curve.

6. The coil deterioration diagnostic method according to claim 1, wherein the AC voltage is represented by a square-wave curve.

7. A coil deterioration diagnostic apparatus comprising: a coil (11) constituted of a conductor (13) to be cooled directly by a medium and internal electrodes (16) wrapped in an insulation layer for covering the conductor; a power supply (12) for applying an AC voltage to the conductor of the coil; a non-contact type surface potentiometer (19), **characterized in that** the surface potentiometer is constructed and arranged to measure the potential of the internal electrode through a potential measuring probe (18); and a voltage reading device (20) for measuring the AC voltage to be applied from the power supply to the conductor.

**Patentansprüche**

1. Diagnoseverfahren für Spulengüteminderung, wobei ein von einem Medium direkt zu kühlender Leiter mit einer Isolierschicht (14, 15) überzogen ist, eine Spule (11) von dem Leiter (13) und von in die Isolierschicht einzuwickelnden inneren Elektroden (16) gebildet ist, an den Leiter der Spule eine Wechselspannung (12) angelegt wird und ein Potential der inneren Elektrode oder Potentiale der inneren Elektroden mit einer der Spule gegenüberliegenden Potentialmeßsonde (18) gemessen werden,

und wobei, wenn ein gemessenes Potential höher als das Potential einer intakten Spule ist, erkannt wird, daß das Medium aus dem Leiter zu der Isolierschicht hin aussickert und die Güte einer Isolierung desselben gemindert ist.

2. Diagnoseverfahren für Spulengüteminderung nach Anspruch 1, wobei dann, wenn das gemessene Potential der inneren Elektrode einen phasenmäßigen Unterschied in Bezug auf eine an den Leiter angelegte Spannung gegenüber der Phase einer intakten Spule aufweist, erkannt wird, daß das Medium aus dem Leiter zu der Isolierschicht hin aussickert und die Güte einer Isolierung desselben gemindert ist.

3. Diagnoseverfahren für Spulengüteminderung nach Anspruch 1, wobei, wenn das gemessene Potential einen durch statistische Verarbeitung erhaltenen Grenzwert übersteigt, erkannt wird, daß das Medium aus dem Leiter zu der Isolierschicht hin aussickert und die Güte einer Isolierung desselben gemindert ist.

4. Diagnoseverfahren für Spulengüteminderung nach Anspruch 1, wobei dann, wenn sich die gemessenen Potentiale abhängig von Positionen der inneren Elektrode unterscheiden, vorläufig ein Standardwert für ein Verhältnis des Potentials der inneren Elektrode zu einem anderen Potential erhalten wird und danach in ein Potential der inneren Elektrode an der gleichen Position umgerechnet wird.

5. Diagnoseverfahren für Spulengüteminderung nach Anspruch 1, wobei die Wechselspannung durch eine Sinuswellenkurve dargestellt wird.

6. Diagnoseverfahren für Spulengüteminderung nach Anspruch 1, wobei die Wechselspannung durch eine Rechteckwellenkurve dargestellt wird.

7. Diagnosevorrichtung für Spulengüteminderung, umfassend: eine Spule (11), die aus einem von einem Medium direkt zu kühlenden Leiter (13) und aus in eine Isolierschicht zum Überziehen des Leiters eingewickelten inneren Elektroden (16) gebildet ist; eine Stromversorgung (12) zum Anlegen einer Wechselspannung an den Leiter der Spule; einberührungsfreies Oberflächenpotentiometer (19),
**dadurch gekennzeichnet, daß** das Oberflächenpotentiometer zum Messen des Potentials der inneren Elektrode durch eine Potentialmeßsonde (18) konstruiert und angeordnet ist; und mit einer Spannungsablesevorrichtung (20) zum Messen der von der Stromversorgung an den Leiter anzulegenden Wechselspannung.

**Revendications**

1. Procédé de diagnostic de détérioration de bobine, dans lequel un conducteur à refroidir directement par un milieu est recouvert d'une couche d'isolation (14, 15), une bobine (11) se compose du conducteur (13) et d'électrodes internes (16) à enrouler dans la couche d'isolation, une tension alternative (12) est appliquée au conducteur de la bobine, et un potentiel de l'électrode interne ou des potentiels des électrodes internes sont mesurés par une sonde de mesure de potentiel (18) faisant face à la bobine,
et dans lequel, si un potentiel mesuré est supérieur au potentiel d'une bobine saine, il est distingué que le milieu fuit du conducteur à la couche d'isolation et que l'isolation de celle-ci est détériorée.

2. Procédé de diagnostic de détérioration de bobine selon la revendication 1, dans lequel, si le potentiel mesuré de l'électrode interne présente une différence de phase concernant une tension appliquée au conducteur par rapport à la phase d'une bobine saine, il est distingué que le milieu fuit du conducteur à la couche d'isolation et que l'isolation de celle-ci est détériorée.

3. Procédé de diagnostic de détérioration de bobine selon la revendication 1, dans lequel, lorsque le potentiel mesuré dépasse une valeur de limite obtenue par un traitement statistique, il est distingué que le milieu fuit du conducteur à la couche d'isolation et que l'isolation est détériorée.

4. Procédé de diagnostic de détérioration de bobine selon la revendication 1, dans lequel les potentiels mesurés diffèrent en fonction des positions de l'électrode interne, une valeur standard pour un taux du potentiel de l'électrode interne ayant un potentiel différent est au préalable obtenue et par la suite convertie en un potentiel de l'électrode interne à la même position.

5. Procédé de diagnostic de détérioration de bobine selon la revendication 1, dans lequel la tension alternative est représentée par une courbe d'onde sinusoïdale.

6. Procédé de diagnostic de détérioration de bobine selon la revendication 1, dans lequel la tension alternative est représentée par une courbe d'onde carrée.

7. Appareil de diagnostic de détérioration de bobine, comprenant : une bobine (11) composée d'un conducteur (13) à refroidir directement par un milieu et d'électrodes internes (16) enroulées dans une couche d'isolation pour recouvrir le conducteur ; une alimentation électrique (12) pour appliquer une tension alternative au conducteur de la bobine ; un potentiomètre de surface de type sans contact (19),
**caractérisé en ce que** le potentiomètre de surface est construit et agencé pour mesurer le potentiel de l'électrode interne à travers une sonde de mesure de potentiel (18) ; et un dispositif de lecture de tension (20) pour mesurer la tension alternative à appliquer de l'alimentation électrique au conducteur.

**FIG. 1**

**FIG. 2**

FIG. 3

FIG. 4

25 — 26

Cc

24 —

Cb

16 —

Ca    Ra

13 — VOLTAGE E

Cf — 27

Ce

— 15

— 14

## FIG. 5

19 —

11 —
29    30
26  15  14    25  24  16
13
12
18    B  A  D    31
C
29  32

## FIG. 6

FIG. 7

FIG. 8

FIG. 9

FIG. 10

FIG. 11

FIG. 12A

FIG. 12B

# F I G. 13

# F I G. 14A

# F I G. 14B

**FIG. 15**

**FIG. 16A**

**FIG. 16B**

FIG. 17A

FIG. 17B

FIG. 18

EP 1 503 218 B1

FIG. 19A

FIG. 19B

FIG. 20A

FIG. 20B

FIG. 21A            FIG. 21B

FIG. 22A            FIG. 22B

FIG. 23

**FIG. 24A**

**FIG. 24B**

FIG. 25A

FIG. 25B

FIG. 26

EP 1 503 218 B1

FIG. 27

FIG. 28